# EUROPEAN PATENT APPLICATION

(11) **EP 4 516 725 A1**
(43) Date of publication of application: **05.03.2025**
(21) Application number: 24179531.9
(22) Date of filing: 03.06.2024
(51) Int. Cl.: B81B 3/00, G01P 15/125, G01C 19/5684

(54) **SENSOR, SENSOR SYSTEM, AND ELECTRONIC DEVICE**

(30) Priority: 29.08.2023 JP 2023139066
(71) Applicant: Kabushiki Kaisha Toshiba, Tokyo 105-0023 (JP)
(72) Inventor: MIYAZAKI, Fumito, Tokyo, 105-0023 (JP); MURASE, Hideaki, Tokyo, 105-0023 (JP); MASUNISHI, Kei, Tokyo, 105-0023 (JP); TOMIZAWA, Yasushi, Tokyo, 105-0023 (JP); ONO, Daiki, Tokyo, 105-0023 (JP); UCHIDA, Kengo, Tokyo, 105-0023 (JP); OGAWA, Etsuji, Tokyo, 105-0023 (JP); OGAWA, Jumpei, Tokyo, 105-0023 (JP); ISHIBASHI, Fumitaka, Tokyo, 105-0023 (JP)
(74) Representative: Hoffmann Eitle

(57) **Abstract**

According to one embodiment, a sensor includes a base including a first face, a fixed portion fixed to the first face, and a movable portion supported by the fixed portion. The movable portion includes a plurality of annular portions and a plurality of connect portions. Each of the plurality of annular portions is provided around the fixed portion with the fixed portion as a center on a first plane along the first face. The plurality of annular portions includes a first annular portion, a second annular portion, and a third annular portion. The plurality of connect portions includes first and second connect portions. The first connect portion is provided between the first and second annular portions, and is connected to the first and second annular portions. The second connect portion is provided between the second and third annular portions, and is connected to the second and third annular portions.

## Description

### FIELD

Embodiments described herein relate generally to a sensor, a sensor system, and an electronic device.

### BACKGROUND

For example, there are sensors having a MEMS (Micro Electro Mechanical Systems) structure. In some cases, electronic devices and the like are controlled based on information obtained by sensors. It is desired to improve the characteristics of sensors.

### BRIEF DESCRIPTION OF THE DRAWINGS

FIG. 1 is a schematic plan view illustrating a sensor according to a first embodiment;
FIG. 2 is a schematic cross-sectional view illustrating the sensor according to the first embodiment;
FIG. 3 is a schematic cross-sectional view illustrating the sensor according to the first embodiment;
FIG. 4 is a schematic plan view illustrating a sensor according to the first embodiment;
FIG. 5 is a schematic plan view illustrating a sensor according to the first embodiment;
FIG. 6 is a schematic plan view illustrating a sensor according to the first embodiment;
FIG. 7 is a schematic plan view illustrating a sensor according to the first embodiment;
FIG. 8 is a schematic diagram illustrating an electronic device according to a second embodiment;
FIGS. 9A to 9H are schematic views illustrating applications of the electronic device according to the embodiment; and
FIGS. 10A and 10B are schematic views illustrating applications of the sensor according to the embodiment.

### DETAILED DESCRIPTION

According to one embodiment, a sensor includes a base including a first face, a fixed portion fixed to the first face, and a movable portion supported by the fixed portion. A gap is provided between the first face and the movable portion. The movable portion includes a plurality of annular portions and a plurality of connect portions. Each of the plurality of annular portions is provided around the fixed portion with the fixed portion as a center on a first plane along the first face. The plurality of annular portions includes a first annular portion, a second annular portion, and a third annular portion. The second annular portion is provided between the first annular portion and the fixed portion. The third annular portion is provided between the second annular portion and the fixed portion. The second annular portion is next to the first annular portion. The third annular portion is next to the second annular portion. The plurality of connect portions includes a first connect portion and a second connect portion. The first connect portion is provided between the first annular portion and the second annular portion, and is connected to the first annular portion and the second annular portion. The second connect portion is provided between the second annular portion and the third annular portion, and is connected to the second annular portion and the third annular portion. The first connect portion and the second connect portion are along a first radial direction. The first radial direction passes through a first center of the fixed portion on the first plane and is along the first plane.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First Embodiment)

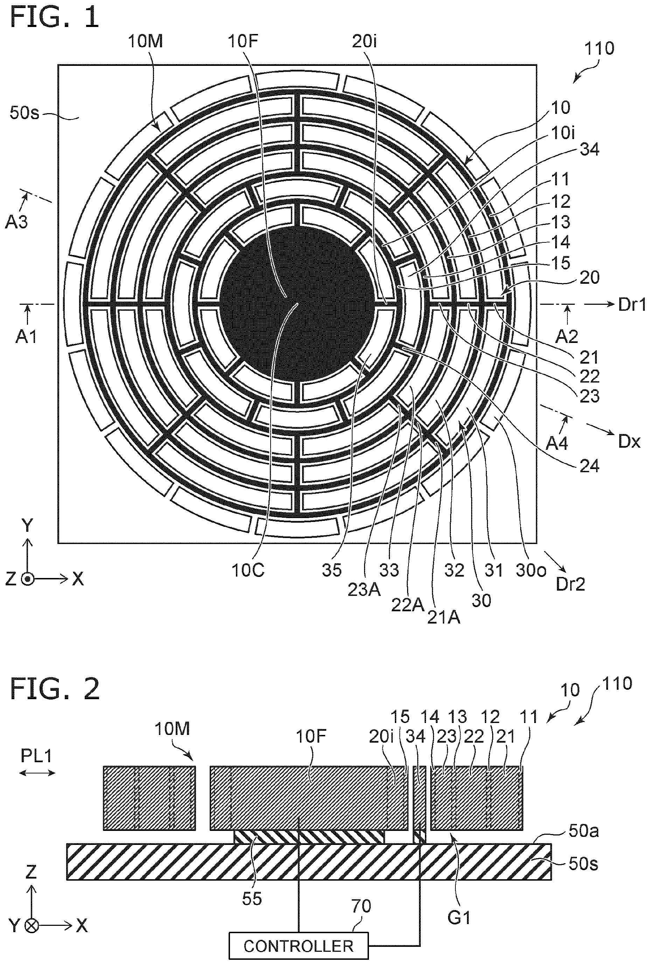

FIG. 1 is a schematic plan view illustrating a sensor according to a first embodiment.

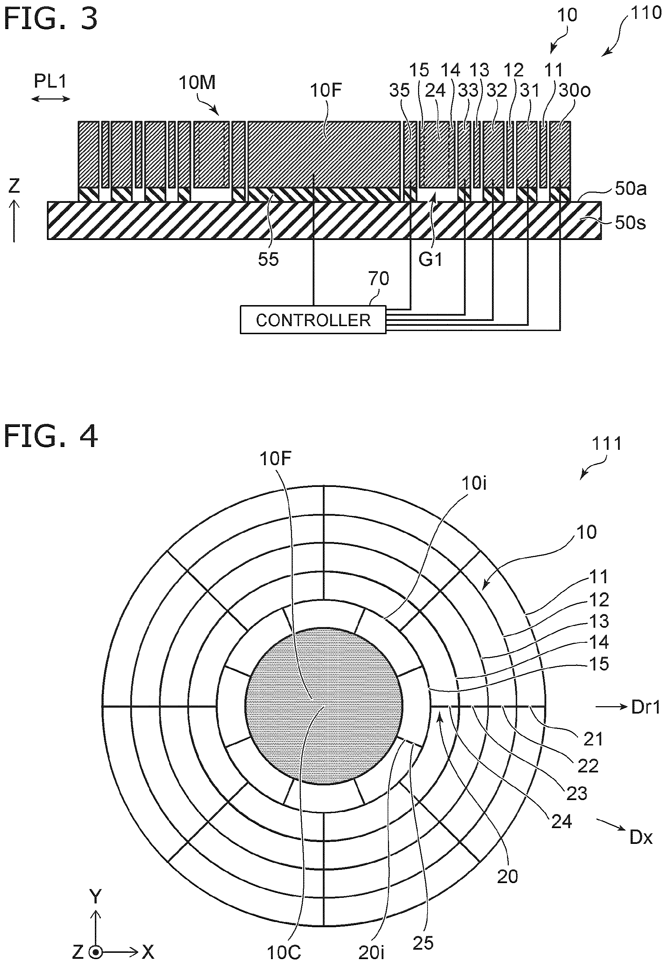

FIGS. 2 and 3 are schematic cross-sectional views illustrating the sensor according to the first embodiment.

FIG. 2 is a sectional view taken along the line A1-A2 in FIG. 1. FIG. 3 is a sectional view taken along the line A3-A4 in FIG. 1.

As shown in FIGS. 1-3, a sensor 110 according to the embodiment includes a base 50s, a fixed portion 10F, and a movable portion 10M.

The base 50s includes a first face 50a. The fixed portion 10F is fixed to the first face 50a. The movable portion 10M is supported by the fixed portion 10F. A gap G1 is provided between the first face 50a and the movable portion 10M. For example, an insulating member 55 is provided on the first face 50a. The fixed portion 10F is provided on the insulating member 55. The insulating member 55 is not provided between the first face 50a and the movable portion 10M.

The movable portion 10M is electrically conductive. The movable portion 10M may include, for example, conductive silicon. The fixed portion 10F is electrically conductive. The fixed portion 10F may include, for example, conductive silicon. The fixed portion 10F is electrically connected to the movable portion 10M. The insulating member 55 may include, for example, silicon oxide.

The movable portion 10M includes a plurality of annular portions 10 and a plurality of connect portions 20. Each of the plurality of annular portions 10 is provided around the fixed portion 10F with the fixed portion 10F as a center on a first plane PL1 along the first face 50a.

A direction perpendicular to the first plane PL1 is defined as a Z-axis direction. One direction perpendicular to the Z-axis direction is defined as an X-axis direction. A direction perpendicular to the Z-axis direction and the X-axis direction is defined as a Y-axis direction. The first plane PL1 is parallel to the X-Y plane.

For example, each of the plurality of annular portions 10 is concentric with the fixed portion 10F as the center. Each of the plurality of annular portions 10 extends along a circumferential direction of the circle.

For example, the plurality of annular portions 10 include a first annular portion 11, a second annular portion 12, and a third annular portion 13. The plurality of annular portions 10 may further include a fourth annular portion 14, a fifth annular portion 15, and the like. The number of the plurality of annular portions 10 is arbitrary.

The second annular portion 12 is provided between the first annular portion 11 and the fixed portion 10F. The third annular portion 13 is provided between the second annular portion 12 and the fixed portion 10F. The second annular portion 12 is next to the first annular portion 11 among the plurality of annular portions 10. The third annular portion 13 is next to the second annular portion 12 among the plurality of annular portions 10. The second annular portion 12 is closest to the first annular portion 11 among the plurality of annular portions 10. The third annular portion 13 is closest to the second annular portion 12 among the plurality of annular portions 10.

The plurality of connect portions 20 include a first connect portion 21 and a second connect portion 22. The plurality of connect portions 20 may include a third connect portion 23, a fourth connect portion 24, and the like. The number of the plurality of connect portions 20 is arbitrary.

The first connect portion 21 is provided between the first annular portion 11 and the second annular portion 12. The first connect portion 21 is connected to the first annular portion 11 and the second annular portion 12. The second connect portion 22 is provided between the second annular portion 12 and the third annular portion 13. The second connect portion 22 is connected to the second annular portion 12 and the third annular portion 13. As shown in FIG. 1, the first connect portion 21 and the second connect portion 22 are along a first radial direction Dr1. The first radial direction Dr1 passes through a first center 10C of the fixed portion 10F on the first plane PL1 and extends along the first plane PL1. In this example, the first radial direction Dr1 is the X-axis direction.

As shown in FIG. 1, a plurality of fixed electrodes 30 are provided in the sensor 110. For example, the plurality of fixed electrodes 30 are fixed to the first face 50a. For example, a signal including an alternating component is applied between the plurality of fixed electrodes 30 and the movable portion 10M. Thereby, the movable portion 10M vibrates. The alternating component may have, for example, a frequency component that excites the resonant vibration of the movable portion 10M. When an external force is applied to the movable portion 10M vibrating, the vibration state changes. By detecting the change in the vibration state, the applied external force can be detected. The change in the vibration state is detected as a change in capacitance, for example. The change in the vibration state due to external forces are caused by, for example, Coriolis force. The change in the vibration state can be detected, for example, by another part of the plurality of fixed electrodes 30. The signal may be supplied by the controller 70, for example. For example, the controller 70 may detect the change in the vibration state.

In the embodiment, at least three of the annular portions 10 adjacent to each other are connected by the connect portions 20 along the first radial direction Dr1. The portions of three of the annular portions 10 connected by the connect portions 20 vibrate in conjunction with each other. This results in a high intensity signal regarding vibrations. At least three of the annular portions 10 adjacent to each other are linearly connected.

For example, there is a first reference example in which the plurality of annular portions 10 adjacent to each other are not connected linearly. In the first reference example, for example, the direction in which the first connect portion 21 extends crosses the direction in which the second connect portion 22 extends. In such a first reference example, the coupling between the plurality of annular portions 10 adjacent to each other is weak. For example, in the case of resonance vibration that vibrates in the radial direction, in the first reference example, the positions where the plurality of annular portions 10 are connected are averaged. In such a first reference example, the plurality of annular portions 10 adjacent to each other do not vibrate in conjunction with each other. Therefore, the strength of the detected signal is low.

In contrast, in the embodiment, at least three of the annular portions 10 adjacent to each other are connected by the connect portions 20 along the first radial direction Dr1. At least three of the annular portions 10 vibrate in conjunction. Thereby, high intensity signal can be detected. For example, high sensitivity can be obtained. For example, a high S/N ratio can be obtained. According to the embodiment, a sensor whose characteristics can be improved can be provided.

On the other hand, for example, in a second reference example, entire of the movable portion 10M has a honeycomb structure. In this case, the direction in which the connect portions 20 extends is not the radial direction. For example, in the case of resonant vibration vibrating in the radial direction, the intensity of the obtained signal is low in such a second reference example.

In contrast, in the embodiment, the plurality of connect portions 20 are along the radial direction. Thereby, at least three of the annular portions 10 connected to each other by connect portions 20 along the radial direction can vibrate in conjunction with each other. A high intensity signal can be obtained. In embodiments, for example, high stiffness is obtained. Stable detection is possible. For example, high vibration resistance and high sensitivity can be obtained.

As shown in FIG. 1, the plurality of connect portions 20 may further include a fixed portion side connect portion 20i. The fixed portion side connect portion 20i is connected to the fixed portion 10F. The fixed portion side connect portion 20i is directly or indirectly connected to the third annular portion 13. In this example, the fixed portion side connect portion 20i is along the first radial direction Dr1. As will be described below, the fixed portion side connect portion 20i may be along a cross radial direction that crosses the first radial direction Dr1.

As shown in FIG. 1, the plurality of annular portions 10 may further include the fourth annular portion 14. The fourth annular portion 14 is provided between the third annular portion 13 and the fixed portion 10F. The fourth annular portion 14 is next to the third annular portion 13 among the plurality of annular portions 10. The fourth annular portion 14 is closest to the third annular portion 13 among the plurality of annular portions 10.

As shown in FIG. 1, the plurality of connect portions 20 further include the third connect portion 23. The third connect portion 23 is provided between the third annular portion 13 and the fourth annular portion 14. The third connect portion 23 is connected to the third annular portion 13 and the fourth annular portion 14. The third connect portion 23 is along the first radial direction Dr1.

As shown in FIG. 1, in this example, the plurality of annular portions 10 further include the fifth annular portion 15. The fifth annular portion 15 is provided between the fourth annular portion 14 and the fixed portion 10F. The fifth annular portion 15 is next to the fourth annular portion 14 among the plurality of annular portions 10. The fifth annular portion 15 is closest to the fourth annular portion 14 among the plurality of annular portions 10.

As shown in FIG. 1, the plurality of connect portions 20 may further include the fourth connect portion 24. The fourth connect portion 24 is provided between the fourth annular portion 14 and the fifth annular portion 15. The fourth connect portion 24 is connected to the fourth annular portion 14 and the fifth annular portion 15. In this example, the fourth connect portion 24 is along a cross-radial direction Dx. The cross-radial direction Dx passes through the first center 10C of the fixed portion 10F, extends along the first plane PL1, and crosses the first radial direction Dr1.

As shown in FIG. 1, the plurality of connect portions 20 may include a first other connect portion 21A and a second other connect portion 22A. The first other connect portion 21A is provided between the first annular portion 11 and the second annular portion 12. The first other connect portion 21A is connected to the first annular portion 11 and the second annular portion 12. The second other connect portion 22A is provided between the second annular portion 12 and the third annular portion 13. The second other connect portion 22A is connected to the second annular portion 12 and the third annular portion 13. The first other connect portion 21A and the second other connect portion 22A are along a second radial direction Dr2. The second radial direction Dr2 passes through the first center 10C of the fixed portion 10F and extends along the first plane PL1. The second radial direction Dr2 crosses the first radial direction Dr1. For example, the second radial direction Dr2 is inclined with respect to the first radial direction Dr1. The angle between the second radial direction Dr2 and the first radial direction Dr1 may be, for example, not less than 5 degrees and not more than 85 degrees. The angle between the second radial direction Dr2 and the first radial direction Dr1 may be, for example, not less than 10 degrees and not more than 60 degrees.

As shown in FIG. 1, the sensor 110 may include the plurality of fixed electrodes 30. The plurality of fixed electrodes 30 are fixed to the first face 50a. For example, the plurality of fixed electrodes 30 include a first fixed electrode 31 and a second fixed electrode 32. The first fixed electrode 31 is provided between the first annular portion 11 and the second annular portion 12. The second fixed electrode 32 is provided between the second annular portion 12 and the third annular portion 13. The first fixed electrode 31 is provided between the first connect portion 21 and the first other connect portion 21A in the circumferential direction around the fixed portion 10F. The second fixed electrode 32 is provided between the second connect portion 22 and the second other connect portion 22A in the circumferential direction.

As already described, the sensor 110 may further include the controller 70. The controller 70 is configured to apply the electrical signal between the fixed portion 10F and the first fixed electrode 31. The electrical signal includes an alternating component.

The plurality of connect portions 20 may further include a third other connect portion 23A. The third other connect portion 23A is provided between the third annular portion 13 and the fourth annular portion 14. The third other connect portion 23A is connected to the third annular portion 13 and the fourth annular portion 14. In this example, the third other connect portion 23A is along the second radial direction Dr2.

For example, the plurality of fixed electrodes 30 may include a third fixed electrode 33. The third fixed electrode 33 is provided between the third annular portion 13 and the fourth annular portion 14. The third fixed electrode 33 is provided between the third connect portion 23 and the third other connect portion 23A in the circumferential direction.

In this example, the plurality of fixed electrodes 30 include a fourth fixed electrode 34. The fourth fixed electrode 34 is provided between the fourth annular portion 14 and the fifth annular portion 15.

In this example, a direction from the fixed portion 10F to the fourth fixed electrode 34 is along the first radial direction Dr1. For example, the fourth fixed electrode 34 is provided between the fixed portion side connect portion 20i and the first connect portion 21. For example, the fifth annular portion 15 is separated from the first connect portion 21, second connect portion 22, and third connect portion 23 extending in the first radial direction Dr1 in the first radial direction Dr1. One of the plurality of fixed electrodes 30 may be provided between the fixed portion 10F and the first connect portion 21.

As shown in FIG. 1, the sensor 110 may further include an outer electrode 30o. The outer electrode 30o is fixed to the first face 50a. The first annular portion 11 is provided between the second annular portion 12 and the outer electrode 30o. The outer electrode 30o may control the movable portion 10M or detect the vibration state.

FIG. 4 is a schematic plan view illustrating a sensor according to the first embodiment.

FIG. 4 illustrates the fixed portion 10F and the movable portion 10M. In a sensor 111 according to the embodiment, the direction in which the fourth connect portion 24 extends is the first radial direction Dr1. The configuration of the sensor 111 except for this may be the same as the configuration of the sensor 110.

In the sensor 111, the plurality of annular portions 10 include the fourth annular portion 14 and the fifth annular portion 15. The fourth annular portion 14 is provided between the third annular portion 13 and the fixed portion 10F. The fifth annular portion is provided between the fourth annular portion 14 and the fixed portion 10F. The fourth annular portion 14 is next to the third annular portion 13 among the plurality of annular portions 10. The fifth annular portion 15 is next to the fourth annular portion 14 among the plurality of annular portions 10. The plurality of connect portions 20 include the fourth connect portion 24. The fourth connect portion 24 is provided between the fourth annular portion 14 and the fifth annular portion 15. The fourth connect portion 24 is connected to the fourth annular portion 14 and the fifth annular portion 15. The fourth connect portion 24 is along the first radial direction Dr1.

In the sensor 111 , the plurality of connect portions 20 include the fifth connect portion 25. The fifth connect portion 25 is provided between the fifth annular portion 15 and the fixed portion 10F. The fifth connect portion 25 is connected to the fifth annular portion 15 and the fixed portion 10F. The fifth connect portion 25 is along the cross-radial direction Dx. The fifth connect portion 25 corresponds to the fixed portion side connect portion 20i.

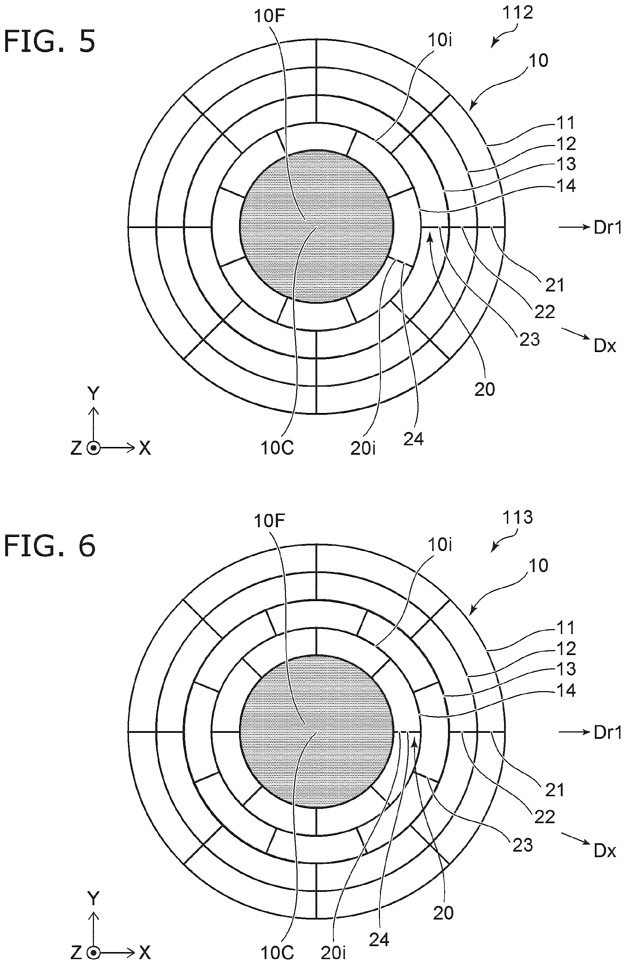

FIG. 5 is a schematic plan view illustrating a sensor according to the first embodiment.

FIG. 5 illustrates the fixed portion 10F and the movable portion 10M. In a sensor 112 according to the embodiment, the direction in which the fourth connect portion 24 extends is the cross-radial direction Dx. The configuration of the sensor 112 except for this may be the same as the configuration of the sensor 110.

FIG. 6 is a schematic plan view illustrating a sensor according to the first embodiment.

FIG. 6 illustrates the fixed portion 10F and the movable portion 10M. In a sensor 113 according to the embodiment, the direction in which the third connect portion 23 extends is the cross-radial direction Dx. The configuration of the sensor 113 except for this may be the same as the configuration of the sensor 110.

As described above, the sensors 110 to 113 include the base 50s including the first face 50a, the fixed portion 10F fixed to the first face 50a, and the movable portion 10M supported by the fixed portion 10F. The gap G1 is provided between the first face 50a and the movable portion 10M. The movable portion 10M includes the plurality of annular portions 10 and the plurality of connect portions 20. Each of the plurality of annular portions 10 is provided around the fixed portion 10F with the fixed portion 10F as the center on the first plane PL1 along the first face 50a. A part of the plurality of connect portions 20 (for example, the first connect portion 21 and the second connect portion 22) extends along the first radial direction Dr1. The first radial direction Dr1 passes through the first center 10C of the fixed portion 10F on the first plane PL1 and extends along the first plane PL1. The part of the plurality of connect portions 20 (the first connect portion 21 and the second connect portion 22, etc.) connects a part of the plurality of annular portions 10 (the first annular portion 11, the second annular portion 12, and the third annular portion 13, etc.) to each other.

Another part of the plurality of connect portions 20 extends along the cross-radial direction Dx. The cross-radial direction Dx passes through the first center 10C of the fixed portion 10F and is along the first plane PL1. The cross-radial direction Dx crosses the first radial direction Dr1. The other part of the plurality of connect portions 20 connects other two of the plurality of annular portions 10 to each other. The other two of the plurality of annular portions 10 are provided between the part of the plurality of annular portions 10 and the fixed portion 10F.

Thus, one of the plurality of annular portions 10 provided inside the plurality of annular portions 10 connected in the first radial direction Dr1 may be connected by the connect portions 20 extending along the cross-radial direction Dx. By providing at least one of the connect portions 20 extending along the cross-radial direction Dx, for example, a part of the plurality of annular portions 10 can be loosely connected, and the vibration state of the movable portion 10M can be appropriately controlled. For example, it is possible to obtain well-balanced vibrations while obtaining a high-strength signal.

As shown in FIG. 1 etc., the plurality of annular portions 10 may include the fixed portion side annular portion 10i. The fixed portion side annular portion 10i is the closest to the fixed portion 10F among the plurality of annular portions 10. For example, the fixed portion side annular portion 10i may be connected to the fixed portion 10F or another one of the plurality of annular portions 10 by one of the plurality of connect portions 20 extending in the cross-radial direction Dx. In this example, the plurality of fixed electrodes 30 include the fifth fixed electrode 35. The fifth fixed electrode 35 is provided between the fixed portion 10F and the fixed portion side annular portion 10i.

The sensors 110 to 113 described above may include the first fixed electrode 31. The first fixed electrode 31 is fixed to the first face 50a. The first fixed electrode 31 is provided between the first annular portion 11 and the second annular portion 12. The direction from the fixed portion 10F to the first fixed electrode 31 is along the cross-radial direction Dx. The first fixed electrode 31 is provided in the cross-radial direction Dx that crosses the first radial direction Dr1 in which one of the connect portions 20 extend. By such a first fixed electrode 31, the vibration state of at least one of the first annular portion 11 or the second annular portion 12 can be effectively detected.

In the embodiment, a plurality of sets including the plurality of connect portions 20 arranged in one radial direction may be provided. The plurality of sets are arranged in the circumferential direction.

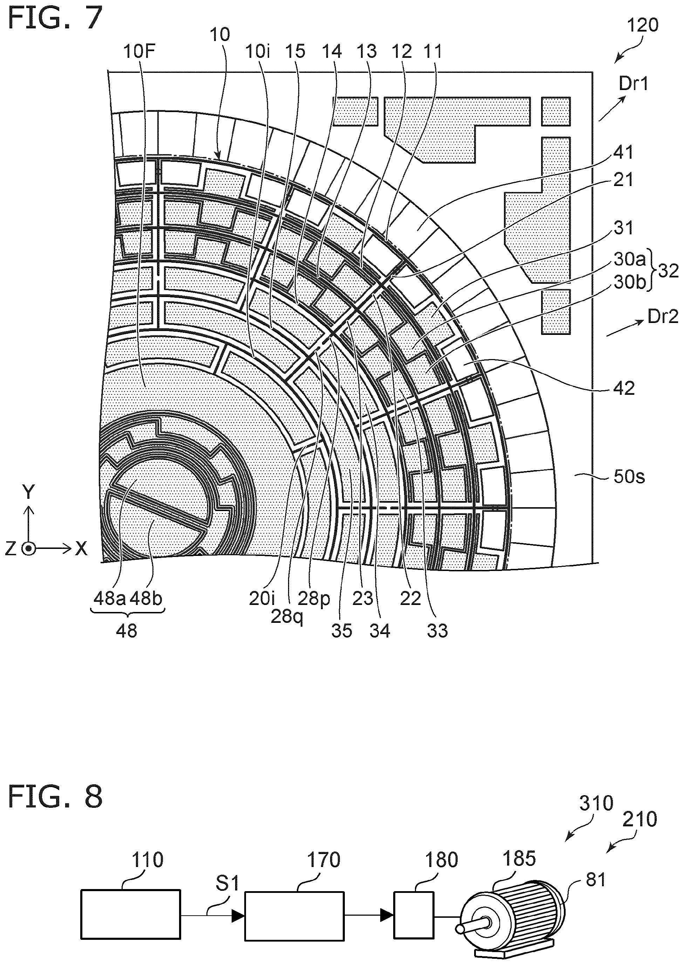

FIG. 7 is a schematic plan view illustrating a sensor according to the first embodiment.

FIG. 7 illustrates the fixed portion 10F and the movable portion 10M. In a sensor 120 according to the embodiment, at least one of the plurality of fixed electrodes 30 includes a plurality of partial electrodes. The configuration of the sensor 120 except for this may be the same as the configuration of the sensor 110, etc.

In this example, at least one of the plurality of fixed electrodes 30 is the second fixed electrode 32. The second fixed electrode 32 includes a plurality of partial electrodes. The plurality of partial electrodes include a first partial electrode 30a and a second partial electrode 30b. For example, a direction from at least a part of the first partial electrode 30a to at least a part of the second partial electrode 30b is along the circumferential direction. In this example, two of the second partial electrode 30b are provided. The first partial electrode 30a is provided between the partial electrodes in the circumferential direction. Different signals may be supplied to the plurality of partial electrodes. By processing the signals obtained from the plurality of partial electrodes, the detection may be performed.

As shown in FIG. 7, the movable portion 10M may further include a first structure 41. The first structure 41 is connected to the first annular portion 11. The first annular portion 11 is provided between the second annular portion 12 and the first structure 41. A width of the first structure 41 along the first radial direction Dr1 is wider than a width of the first annular portion 11 along the first radial direction Dr1. The first structure 41 functions as a first mass body. The vibration characteristics can be controlled by the first structure 41. By the first structure 41, the resonance frequency is adjusted, for example.

As shown in FIG. 7, the movable portion 10M may further include a second structure 42. The second structure 42 is connected to the first annular portion 11. The second structure 42 is provided between the first annular portion 11 and the second annular portion 12. A width of the second structure 42 along the first radial direction Dr1 is wider than the width of the first annular portion 11 along the first radial direction Dr1. The second structure 42 functions as a second mass body. The vibration characteristics can be controlled. For example, it is possible to adjust the resonance frequency.

As shown in FIG. 7, the movable portion 10M may further include a first radial structure 28p. The first radial structure 28p is connected to one of the plurality of annular portions 10. In this example, the first radial structure 28p is connected to the fourth annular portion 14. The first radial structure 28p extends from the one of the plurality of annular portions 10 along the first radial direction Dr1. The first radial structure 28p is separated from another one of the plurality of annular portions 10 in the first radial direction Dr1. In this example, the first radial structure 28p is separated from the fifth annular portion 15 in the first radial direction Dr1. The other one of the plurality of annular portions 10 is next to the one of the plurality of annular portions 10 among the plurality of annular portions 10. The other one of the plurality of annular portions 10 is closest to the one of the plurality of annular portions 10 among the plurality of annular portions 10.

The movable portion 10M may further include a second radial structure 28q. The second radial structure 28q is connected to the other one of the plurality of annular portions 10. The second radial structure 28q is connected to the fifth annular portion 15. The second radial structure 28q extends from the other one of the plurality of annular portions 10 toward the one of the plurality of annular portions 10 along the first radial direction Dr1. The second radial structure 28q extends from the fifth annular portion 15 toward the fourth annular portion 14 along the first radial direction Dr1. The second radial structure 28q is separated from the first radial structure 28p in the first radial direction Dr1.

By providing such a radial structure, the overall mass distribution can be made uniform without connecting adjacent annular portions. It becomes easier to obtain higher characteristics.

As shown in FIG. 7, the sensor 120 may include a connecting member 48. The connecting member 48 is fixed to the first face 50a. The fixed portion 10F is provided around the connecting member 48. Electrical connections may be made via the connecting member 48. In this example, the connecting member 48 includes a first connecting member 48a and a second connecting member 48b. The connecting member 48 (for example, the first connecting member 48a and the second connecting member 48b) may be electrically insulated from the fixed portion 10F and the movable portion 10M. At least a part of the connecting member 48 (for example, the first connecting member 48a and the second connecting member 48b, etc.) may be electrically connected to the fixed portion 10F or the movable portion 10M by wiring for electrical connection.

### (Second Embodiment)

A second embodiment relates to an electronic device.

FIG. 8 is a schematic diagram illustrating an electronic device according to a second embodiment.

As shown in FIG. 8, an electronic device 310 according to the embodiment includes the sensors according to the first to third embodiments and the circuit processor 170. In the example of FIG. 8, the sensor 110 is drawn as the sensor. The circuit processor 170 is configured to control a circuit 180 based on the signal S1 obtained from the sensor. The circuit 180 is, for example, a control circuit for a drive device 185. According to the embodiment, for example, the circuit 180 for controlling the drive device 185 can be controlled with high accuracy.

As shown in FIG. 8, the sensor system 210 according to the embodiment includes the sensor (for example, the sensor 110) according to the first embodiment and a detection target member 81. The sensor 110 is fixed to the detection target member 81. The sensor 110 can detect a signal from the detection target member 81.

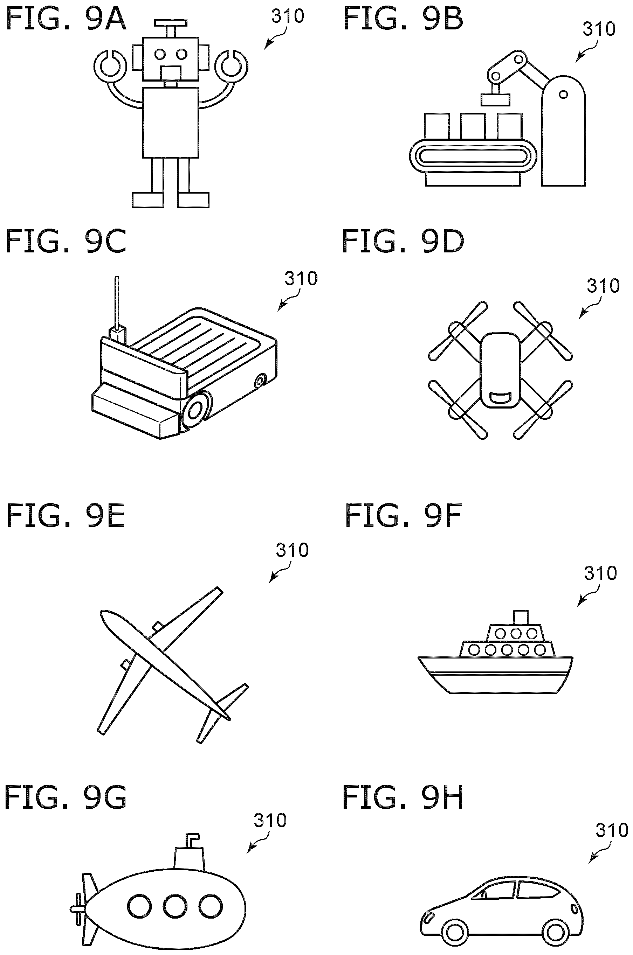

FIGS. 9A to 9H are schematic views illustrating applications of the electronic device according to the embodiment.

As shown in FIG. 9A, the electronic device 310 may be at least a portion of a robot. As shown in FIG. 9B, the electronic device 310 may be at least a portion of a machining robot provided in a manufacturing plant, etc. As shown in FIG. 9C, the electronic device 310 may be at least a portion of an automatic guided vehicle inside a plant, etc. As shown in FIG. 9D, the electronic device 310 may be at least a portion of a drone (an unmanned aircraft). As shown in FIG. 9E, the electronic device 310 may be at least a portion of an airplane. As shown in FIG. 9F, the electronic device 310 may be at least a portion of a ship. As shown in FIG. 9G, the electronic device 310 may be at least a portion of a submarine. As shown in FIG. 9H, the electronic device 310 may be at least a portion of an automobile. The electronic device 310 may include, for example, at least one of a robot or a moving body.

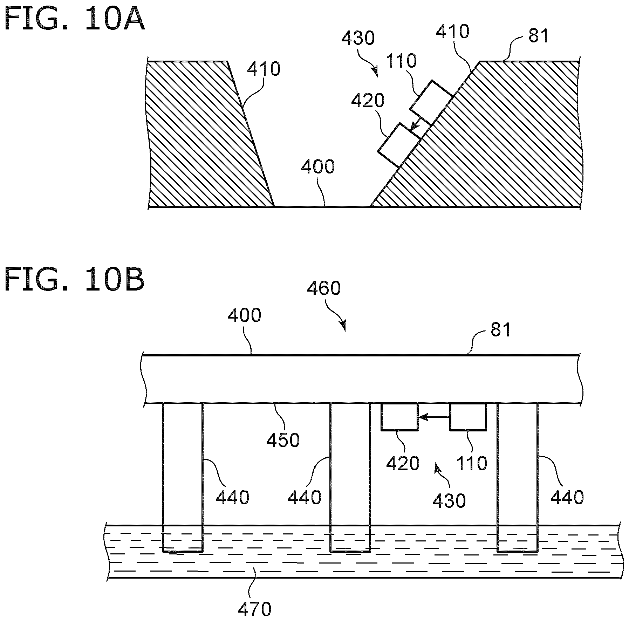

FIGS. 10A and 10B are schematic views illustrating applications of the sensor according to the embodiment.

As shown in FIG. 10A, a sensor 430 according to the fifth embodiment includes the sensor according to one of the first to third embodiments, and a transmission/reception part 420. In the example of FIG. 10A, the sensor 110 is illustrated as the sensor. The transmission/reception part 420 is configured to transmit the signal obtained from the sensor 110 by, for example, at least one of wireless and wired methods. The sensor 430 is provided on, for example, a slope surface 410 such as a road 400. The sensor 430 can monitor the state of, for example, a facility (e.g., infrastructure). The sensor 430 may be, for example, a state monitoring device.

For example, the sensor 430 detects a change in the state of a slope surface 410 of a road 400 with high accuracy. The change in the state of the slope surface 410 includes, for example, at least one of a change in the inclination angle and a change in the vibration state. The signal (inspection result) obtained from the sensor 110 is transmitted by the transmission/reception part 420. The status of a facility (e.g., infrastructure) can be monitored, for example, continuously.

As shown in FIG. 10B, the sensor 430 is provided, for example, in a portion of a bridge 460. The bridge 460 is provided above the river 470. For example, the bridge 460 includes at least one of a main girder 450 and a pier 440. The sensor 430 is provided on at least one of the main girder 450 and the pier 440. For example, at least one of the angles of the main girder 450 and the pier 440 may change due to deterioration or the like. For example, the vibration state may change in at least one of the main girder 450 and the pier 440. The sensor 430 detects these changes with high accuracy. The detection result can be transmitted to an arbitrary place by the transmission/reception part 420. Abnormalities can be detected effectively.

The embodiments may include the following Technical proposals:

### (Technical proposal 1)

A sensor, comprising:
a base including a first face;
a fixed portion fixed to the first face; and
a movable portion supported by the fixed portion,
a gap being provided between the first face and the movable portion,
the movable portion including a plurality of annular portions and a plurality of connect portions,
each of the plurality of annular portions being provided around the fixed portion with the fixed portion as a center on a first plane along the first face,
the plurality of annular portions including a first annular portion, a second annular portion, and a third annular portion,
the second annular portion being provided between the first annular portion and the fixed portion,
the third annular portion being provided between the second annular portion and the fixed portion,
the second annular portion being next to the first annular portion,
the third annular portion being next to the second annular portion,
the plurality of connect portions including a first connect portion and a second connect portion,
the first connect portion being provided between the first annular portion and the second annular portion, and being connected to the first annular portion and the second annular portion,
the second connect portion being provided between the second annular portion and the third annular portion, and being connected to the second annular portion and the third annular portion,
the first connect portion and the second connect portion being along a first radial direction, and
the first radial direction passing through a first center of the fixed portion on the first plane, the first radial direction being along the first plane.

### (Technical proposal 2)

The sensor according to Technical proposal 1, wherein
the plurality of connect portions further include a fixed portions side connect portion,
the fixed portion side connect portion is connected to the fixed portion,
the fixed portion side connect portion is directly or indirectly connected to the third annular portion, and
the fixed portion side connect portion is along the first radial direction.

### (Technical proposal 3)

The sensor according to Technical proposal 1, wherein
the plurality of connect portions further include a fixed portions side connect portion,
the fixed portion side connect portion is connected to the fixed portion,
the fixed portion side connect portion is directly or indirectly connected to the third annular portion,
the fixed portion side connect portion is along a cross-radial direction, and
the cross-radial direction passes through the first center, the cross-radial direction is along the first plane, and the cross-radial direction crosses the first radial direction.

### (Technical proposal 4)

The sensor according to Technical proposal 1 or 2, wherein
the plurality of annular portions further include a fourth annular portion,
the fourth annular portion is provided between the third annular portion and the fixed portion,
the fourth annular portion is next to the third annular portion,
the plurality of connect portions further includes a third connect portion,
the third connect portion is provided between the third annular portion and the fourth annular portion, and is connected to the third annular portion and the fourth annular portion, and
the third connect portion is along the first radial direction.

### (Technical proposal 5)

The sensor according to Technical proposal 4, wherein
the plurality of annular portions further include a fifth annular portion,
the fifth annular portion is provided between the fourth annular portion and the fixed portion,
the fifth annular portion is next to the fourth annular portion,
the plurality of connect portions further includes a fourth connect portion,
the fourth connect portion is provided between the fourth annular portion and the fifth annular portion, and is connected to the fourth annular portion and the fifth annular portion, and
the fourth connect portion is along the first radial direction.

### (Technical proposal 6)

The sensor according to Technical proposal 4, wherein
the plurality of annular portions further include a fifth annular portion,
the fifth annular portion is provided between the fourth annular portion and the fixed portion,
the fifth annular portion is next to the fourth annular portion,
the plurality of connect portions further includes a fourth connect portion,
the fourth connect portion is provided between the fourth annular portion and the fifth annular portion, and is connected to the fourth annular portion and the fifth annular portion,
the fourth connect portion is along a cross-radial direction, and
the cross-radial direction passes through the first center, the cross-radial direction is along the first plane, the cross-radial direction crosses the first radial direction.

### (Technical proposal 7)

The sensor according to Technical proposal 1, wherein
the plurality of annular portions further include a fourth annular portion,
the fourth annular portion is provided between the third annular portion and the fixed portion,
the fourth annular portion is next to the third annular portion,
the plurality of connect portions further includes a third connect portion,
the third connect portion is provided between the third annular portion and the fourth annular portion, and is connected to the third annular portion and the fourth annular portion,
the third connect portion is along a cross-radial direction, and
the cross-radial direction passes through the first center, the cross-radial direction is along the first plane, the cross-radial direction crosses the first radial direction.

### (Technical proposal 8)

The sensor according to any one of Technical proposals 1-7, wherein
the plurality of connect portions include a first other connect portion and a second other connect portion,
the first other connect portion is provided between the first annular portion and the second annular portion, and is connected to the first annular portion and the second annular portion,
the second other connect portion is provided between the second annular portion and the third annular portion, and is connected to the second annular portion and the third annular portion,
the first other connect portion and the second other connect portion are along a second radial direction, and
the second radial direction passes through the first center, the second radial direction is along the first plane, the second radial direction crosses the first radial direction.

### (Technical proposal 9)

The sensor according to Technical proposal 8, further comprising:
a plurality of fixed electrodes fixed to the first face,
the plurality of fixed electrodes including a first fixed electrode and a second fixed electrode,
the first fixed electrode being provided between the first annular portion and the second annular portion,
the second fixed electrode being provided between the second annular portion and the third annular portion,
the first fixed electrode being provided between the first connect portion and the first other connect portion in a circumferential direction with the fixed portion as a center, and
the second fixed electrode being provided between the second connect portion and the second other connect portion in the circumferential direction.

### (Technical proposal 10)

The sensor according to Technical proposal 9, wherein
at least one of the plurality of fixed electrodes includes a plurality of partial electrodes, and
a direction from at least a part of one of the plurality of partial electrodes to at least a part of another one of the plurality of partial electrodes is along the circumferential direction.

### (Technical proposal 11)

The sensor according to Technical proposal 9 or 10, further comprising:
a controller configured to apply an electrical signal between the fixed portion and the first fixed electrode.

### (Technical proposal 12)

The sensor according to any one of Technical proposals 1-11, wherein
the movable portion further includes a first structure,
the first structure is connected to the first annular portion, and
the first annular portion is provided between the second annular portion and the first structure.

### (Technical proposal 13)

The sensor according to Technical proposal 1, wherein
the movable portion further includes a first radial structure,
the first radial structure is connected to one of the plurality of annular portions,
the first radial structure extends along the first radial direction from the one of the plurality of annular portions,
the first radial structure is separated from another one of the plurality of annular portion in the first radial direction, and
the other one of the plurality of annular portions is next to the one of the plurality of annular portions.

### (Technical proposal 14)

The sensor according to Technical proposal 13, wherein
the movable portion further includes a second radial structure,
the second radial structure is connected to the other one of the plurality of annular portions,
the second radial structure extends along the first radial direction from the other one of the plurality of annular portions toward the one of the plurality of annular portions, and
the second radial structure is separated from the first radial structure in the first radial direction.

### (Technical proposal 15)

The sensor according to Technical proposal 1, further comprising:
an outer electrode fixed to the first face, and
the first annular portion being provided between the second annular portion and the outer electrode.

### (Technical proposal 16)

A sensor, comprising:
a base including a first face;
a fixed portion fixed to the first face; and
a movable portion supported by the fixed portion,
a gap being provided between the first face and the movable portion,
the movable portion including a plurality of annular portions and a plurality of connect portions,
each of the plurality of annular portions being provided around the fixed portion with the fixed portion as a center on a first plane along the first face,
a part of the plurality of connection portions extends along a first radial direction,
the first radial direction passing through a first center of the fixed portion in the first plane and being along the first plane, and
the part of the plurality of connect portions connecting parts of the plurality of annular portions to each other.

### (Technical proposal 17)

The sensor according to Technical proposal 16, wherein
another part of the plurality of connect portions extends along a cross-radial direction,
the cross-radial direction passes through the first center, the cross-radial direction is along the first plane, the cross-radial direction crosses the first radial direction,
the other part of the plurality of connect portions connects other two of the plurality of annular portions to each other, and
the other two of the plurality of annular portions are provided the part of the plurality of annular portions and the fixed portion.

### (Technical proposal 18)

The sensor according to Technical proposal 3, further comprising:
a first fixed electrode fixed to the first face,
the first fixed electrode being between the first annular portion and the second annular portion, and
a direction from the fixed portion to the first fixed electrode being along the cross radiation direction.

### (Technical proposal 19)

A sensor system, comprising:
the sensor according to Technical proposal 1; and
a detection target member, the sensor being fixed to the detection target member.

### (Technical proposal 20)

An electronic device, comprising:
the sensor according to any one of Technical proposals 1-18; and
a circuit controller configured to control a circuit based on a signal obtained from the sensor.

According to the embodiment, a sensor, a sensor system, and an electronic device whose characteristics can be improved can be provided.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in the sensor such as members, substrates, sensor sections, housings, sensor elements, bases, fixed portions, movable portions, controllers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all sensors, all sensor systems, and all electronic devices practicable by an appropriate design modification by one skilled in the art based on the sensors, the sensor systems, and the electronic devices described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A sensor, comprising:
a base including a first face;
a fixed portion fixed to the first face; and
a movable portion supported by the fixed portion,
a gap being provided between the first face and the movable portion,
the movable portion including a plurality of annular portions and a plurality of connect portions,
each of the plurality of annular portions being provided around the fixed portion with the fixed portion as a center on a first plane along the first face,
the plurality of annular portions including a first annular portion, a second annular portion, and a third annular portion,
the second annular portion being provided between the first annular portion and the fixed portion,
the third annular portion being provided between the second annular portion and the fixed portion,
the second annular portion being next to the first annular portion,
the third annular portion being next to the second annular portion,
the plurality of connect portions including a first connect portion and a second connect portion,
the first connect portion being provided between the first annular portion and the second annular portion, and being connected to the first annular portion and the second annular portion,
the second connect portion being provided between the second annular portion and the third annular portion, and being connected to the second annular portion and the third annular portion,
the first connect portion and the second connect portion being along a first radial direction, and
the first radial direction passing through a first center of the fixed portion on the first plane, the first radial direction being along the first plane.

2. The sensor according to claim 1, wherein
the plurality of connect portions further include a fixed portions side connect portion,
the fixed portion side connect portion is connected to the fixed portion,
the fixed portion side connect portion is directly or indirectly connected to the third annular portion, and
the fixed portion side connect portion is along the first radial direction.

3. The sensor according to claim 1, wherein
the plurality of connect portions further include a fixed portions side connect portion,
the fixed portion side connect portion is connected to the fixed portion,
the fixed portion side connect portion is directly or indirectly connected to the third annular portion,
the fixed portion side connect portion is along a cross-radial direction, and
the cross-radial direction passes through the first center, the cross-radial direction is along the first plane, and the cross-radial direction crosses the first radial direction.

4. The sensor according to claim 1 or 2, wherein
the plurality of annular portions further include a fourth annular portion,
the fourth annular portion is provided between the third annular portion and the fixed portion,
the fourth annular portion is next to the third annular portion,
the plurality of connect portions further includes a third connect portion,
the third connect portion is provided between the third annular portion and the fourth annular portion, and is connected to the third annular portion and the fourth annular portion, and
the third connect portion is along the first radial direction.

5. The sensor according to claim 4, wherein
the plurality of annular portions further include a fifth annular portion,
the fifth annular portion is provided between the fourth annular portion and the fixed portion,
the fifth annular portion is next to the fourth annular portion,
the plurality of connect portions further includes a fourth connect portion,
the fourth connect portion is provided between the fourth annular portion and the fifth annular portion, and is connected to the fourth annular portion and the fifth annular portion, and
the fourth connect portion is along the first radial direction.

6. The sensor according to claim 4, wherein
the plurality of annular portions further include a fifth annular portion,
the fifth annular portion is provided between the fourth annular portion and the fixed portion,
the fifth annular portion is next to the fourth annular portion,
the plurality of connect portions further includes a fourth connect portion,
the fourth connect portion is provided between the fourth annular portion and the fifth annular portion, and is connected to the fourth annular portion and the fifth annular portion,
the fourth connect portion is along a cross-radial direction, and
the cross-radial direction passes through the first center, the cross-radial direction is along the first plane, the cross-radial direction crosses the first radial direction.

7. The sensor according to claim 1, wherein
the plurality of annular portions further include a fourth annular portion,
the fourth annular portion is provided between the third annular portion and the fixed portion,
the fourth annular portion is next to the third annular portion,
the plurality of connect portions further includes a third connect portion,
the third connect portion is provided between the third annular portion and the fourth annular portion, and is connected to the third annular portion and the fourth annular portion,
the third connect portion is along a cross-radial direction, and
the cross-radial direction passes through the first center, the cross-radial direction is along the first plane, the cross-radial direction crosses the first radial direction.

8. The sensor according to any one of claims 1-7, wherein
the plurality of connect portions include a first other connect portion and a second other connect portion,
the first other connect portion is provided between the first annular portion and the second annular portion, and is connected to the first annular portion and the second annular portion,
the second other connect portion is provided between the second annular portion and the third annular portion, and is connected to the second annular portion and the third annular portion,
the first other connect portion and the second other connect portion are along a second radial direction, and
the second radial direction passes through the first center, the second radial direction is along the first plane, the second radial direction crosses the first radial direction.

9. The sensor according to claim 8, further comprising:
a plurality of fixed electrodes fixed to the first face,
the plurality of fixed electrodes including a first fixed electrode and a second fixed electrode,
the first fixed electrode being provided between the first annular portion and the second annular portion,
the second fixed electrode being provided between the second annular portion and the third annular portion,
the first fixed electrode being provided between the first connect portion and the first other connect portion in a circumferential direction with the fixed portion as a center, and
the second fixed electrode being provided between the second connect portion and the second other connect portion in the circumferential direction.

10. The sensor according to claim 9, wherein
at least one of the plurality of fixed electrodes includes a plurality of partial electrodes, and
a direction from at least a part of one of the plurality of partial electrodes to at least a part of another one of the plurality of partial electrodes is along the circumferential direction.

11. The sensor according to any one of claims 1-10, wherein
the movable portion further includes a first structure,
the first structure is connected to the first annular portion, and
the first annular portion is provided between the second annular portion and the first structure.

12. The sensor according to any one of claims 1-11, wherein
the movable portion further includes a first radial structure,
the first radial structure is connected to one of the plurality of annular portions,
the first radial structure extends along the first radial direction from the one of the plurality of annular portions,
the first radial structure is separated from another one of the plurality of annular portion in the first radial direction, and
the other one of the plurality of annular portions is next to the one of the plurality of annular portions.

13. The sensor according to claim 12, wherein
the movable portion further includes a second radial structure,
the second radial structure is connected to the other one of the plurality of annular portions,
the second radial structure extends along the first radial direction from the other one of the plurality of annular portions toward the one of the plurality of annular portions, and
the second radial structure is separated from the first radial structure in the first radial direction.

14. A sensor system, comprising:
the sensor according to claim 1; and
a detection target member, the sensor being fixed to the detection target member.

15. An electronic device, comprising:
the sensor according to any one of claims 1-13; and
a circuit controller configured to control a circuit based on a signal obtained from the sensor.
